Europäisches Patentamt

European Patent Office

Office européen des brevets

(19)

(11) Veröffentlichungsnummer: **0 181 383**

**B1**

(12) # EUROPÄISCHE PATENTSCHRIFT

(45) Veröffentlichungstag der Patentschrift:
**12.10.88**

(51) Int. Cl.⁴: **G 01 N 24/06**, H 01 F 7/20

(21) Anmeldenummer: **85902458.0**

(22) Anmeldetag: **15.05.85**

(86) Internationale Anmeldenummer:
**PCT/DE 85/00164**

(87) Internationale Veröffentlichungsnummer:
**WO 85/05448 (05.12.85 Gazette 85/26)**

(54) **KERNSPINTOMOGRAPH.**

(30) Priorität: **19.05.84 DE 3418812**

(43) Veröffentlichungstag der Anmeldung:
**21.05.86 Patentblatt 86/21**

(45) Bekanntmachung des Hinweises auf die Patenterteilung:
**12.10.88 Patentblatt 88/41**

(84) Benannte Vertragsstaaten:
**DE GB NL**

(56) Entgegenhaltungen:
**EP-A-0 086 560**
**DE-A-3 123 493**
**FR-A-2 551 258**
**US-A-3 345 523**

(73) Patentinhaber: **Bruker Medizintechnik GmbH, Silberstreifen, D-7512 Rheinstetten- Forchheim (DE)**

(72) Erfinder: **KNÜTTEL, Bertold, Baumgartenstrasse 5, D-7512 Rheinstetten 2 (DE)**
Erfinder: **LAUKIEN, Günther, Rudi, Silberstreifen, D-7512 Rheinstetten- Forchheim (DE)**

(74) Vertreter: **Patentanwälte Kohler - Schwindling - Späth, Hohentwielstrasse 41, D-7000 Stuttgart 1 (DE)**

LIBER, STOCKHOLM 1988

**Beschreibung**

Die Erfindung geht aus von einem Kernspintomographen mit einem Magnetsystem, in dessen einer Achse eine vorzugsweise längsverschiebliche und langgestreckte Halterung für ein Meßobjekt angeordnet ist, wobei das Meßobjekt ferner von Spulensystemen zum Erzeugen von Gradientenfeldern und zum Einstrahlen eines Hochfrequenzfeldes umgeben ist.

Eine derartige Anordnung ist aus der DE-A-3 123 493 bekannt.

Unter Kernspintomographie oder NMR-Tomographie versteht man ein Verfahren, bei dem ein Meßobjekt, insbesondere ein lebender menschlicher oder tierischer Körper gleichzeitig einem starken homogenen Magnetfeld und einem dazu senkrecht ausgerichteten Hochfrequenzfeld ausgesetzt wird. Gleichzeitig wird im Bereiche des Meßobjektes ein in gleicher Richtung wie das homogene Magnetfeld wirkendes Gradientenfeld erzeugt, dessen Stärke in der Achse des Meßobjektes abnimmt. Strahlt man nun das Hochfrequenzfeld ein, wird lediglich im Bereich einer Ebene des Meßobjektes eine kernmagnetische Resonanz hervorgerufen, da lediglich im Bereich dieser Ebene das Magnetfeld infolge des wirksamen Gradientenfeldes eine Stärke hat, die über das gyromagnetische Verhältnis von Protonen der Frequenz des eingestrahlten Hochfrequenzfeldes entspricht. Auf diese Weise ist es möglich, Schnittbilder des Meßobjektes zu erzeugen.

Um ausreichende Meßsignale zu erhalten, ist es erforderlich, bei relativ hohen Magnetfeldstärken zu arbeiten. Bekannte Kernspintomographen arbeiten beispielsweise bei einem Magnetfeld mit einer Stärke von 0,23 Tesla.

Andererseits sind, um beispielsweise Messungen am menschlichen Körper vornehmen zu können, verhältnismäßig große Probenräume erforderlich. Aus diesem Grunde hat man bisher im wesentlichen Magnetsysteme verwendet, die mit Luftspulen aufgebaut waren, wobei diese Luftspulen entweder normalleitend oder supraleitend betrieben wurden. Diese Luftspulen haben jedoch mehrere Nachteile.

Zum einen beeinflussen bereits geringe Feldstörungen außerhalb des Magnetsystems die erforderliche extreme Magnetfeldhomogenität im Probenraum. Derartige Störungen können entweder ortsfest sein, beispielsweise Stahlarmierungen in den Wänden des Raumes, in dem der Kernspintomograph installiert ist, es können jedoch auch bewegliche Störungen sein, beispielsweise in der Nähe des Tomographen bewegte Gerätewagen oder sogar außerhalb des Untersuchungsgebäudes vorbeifahrende Fahrzeuge.

Zum anderen geht von Luftspulenanordnungen ein erhebliches Streufeld aus, da sich das in der Achse der Luftspule erstreckende homogene Magnetfeld über den Außenraum der Luftspule schließt. Dieses Luftspulen-Streufeld beeinflußt in der Nähe des Magnetsystems stehende Einrichtungen, beispielsweise elektronische Geräte, Datenverarbeitungsanlagen und radiologische Geräte in einer Klinik. Darüber hinaus kann das Streufeld sich auch störend auf Herzschrittmacher auswirken, so daß für einen Herzschrittmacher-Patienten ein Aufenthalt in der Nähe des Magnetsystems mit Gefahren verbunden sein kann.

Zwar sieht die eingangs genannte bekannte Einrichtung zur Vermeidung dieser Nachteile bereits eine Abschirmung aus weichmagnetischem Material vor, die einen Großteil des Streufeldes aufnimmt, aufgrund der Solenoidbauweise der Spule, bei der die Richtung des Konstantmagnetfeldes in der Spulenachse liegt, tritt jedoch durch die Öffnung, die zum Einbringen des Meßobjektes erforderlich ist immer noch ein beträchtlicher Teil des Streufeldes aus.

Neben diesen, das Streufeld betreffenden Nachteilen hat jedoch ein Magnetsystem mit einer Luftspulenanordnung in Gestalt von Helmholtz-Anordnung oder als Solenoid noch einen weiteren Nachteil, der sich aus der Spulengeometrie ergibt.

Wie bereits erwähnt, verläuft das Konstantmagnetfeld bei diesen Spulen in Richtung der Spulenachse und damit auch in Richtung der Längsachse des Patienten. Die Spulen, die zum Einstrahlen des Hochfrequenzfeldes erforderlich sind, müssen daher eine sattelförmige Gestalt haben, da sich das Hochfrequenzfeld senkrecht zum Konstantmagnetfeld erstrecken muß. Diese sattelförmigen Hochfrequenzspulen, die nicht nur zum Einstrahlen des Hochfrequenzfeldes, sondern auch zum Empfangen des Meßsignales dienen, haben jedoch einen verhältnismäßig schlechten Wirkungsgrad, der in der Praxis um einen Faktor 2,5 unter demjenigen liegt, der mit einer ihrerseits solenoidförmigen Hochfrequenz-Sende- und Empfangsspule erzielbar ist.

Schließlich haben normalleitende Luftspulensysteme noch den bekannten Nachteil, daß das Umsetzungsverhältnis, das heißt das Verhältnis von erzielter Magnetfeldstärke zu eingesetzter elektrischer Energie relativ schlecht ist, so daß zum Speisen derartiger normalleitender Luftspulensysteme große Netzgeräte mit erheblichem Energieverbrauch erforderlich sind.

Der Erfindung liegt demgegenüber die Aufgabe zugrunde, einen Kernspintomographen der eingangs genannten Art dahingehend weiterzubilden, daß magnetische Störwirkungen von außen nach innen sowie von innen nach außen minimiert werden, daß Kochfrequenzspulenanordnungen mit hohem Wirkungsgrad verwendet werden können und daß zum Erzielen hoher Feldstärken nur eine verhältnismäßig geringe elektrische Leistung eingesetzt werden muß. Dabei sollen jedoch die Vorteile bekannter Einrichtungen, insbesondere

leichte Zugänglichkeit des Probenraumes, ungeschmälert erhalten bleiben.

Diese Aufgabe wird erfindungsgemäß dadurch gelöst, daß das Magnetsystem einen eine Längsöffnung zur Aufnahme des Meßobjektes umschließenden Jocheisenkörper aufweist, wobei in äußeren Randbereichen der Längsöffnung Spulenabschnitte in Richtung der Längsöffnung verlaufen, die im Austrittsbereich aus der Längsöffnung abgekröpft sind und sich oberhalb der Längsöffnung schließen.

Der erfindungsgemäße Tomograph hat damit den Vorteil, daß magnetische Störungen von außen nach innen und von innen nach außen weitgehend dadurch unterdrückt werden, daß ein nahezu allseits geschlossener Eisenkörper verwendet wird, in dem sich das Magnetfeld schließt und lediglich einen Luftraum zur Aufnahme des Meßobjektes durchsetzt, der im gesamten Längsbereich vom Eisenkörper umschlossen ist. Das Konstantmagnetfeld im Luftraum wird dabei von ebenen Eisenflächen begrenzt, so daß solenoidförmige Hochfrequenz-Spulenanordnungen verwendet werden können, mit denen eine bessere Signalausbeute erzielbar ist. Schließlich gestattet das erfindungsgemäß verwendete Eisenmagnetsystem den Einsatz von Netzgeräten niedriger Leistung, da mit einem derartigen System bekanntlich höhere Feldstärken mit geringerem Energieeinsatz erreichbar sind.

Zwar ist aus der DE-A-2 854 774 bereits ein Kernspintomograph bekannt, bei dem ein menschlicher Körper in einem Elektromagnetsystem angeordnet ist, das ebenfalls ferromagnetische Teile umfassen kann, bei dieser bekannten Anordnung ist der Patient jedoch mindestens während der Messung allseits von Magnetspulen und nicht näher bezeichneten Elektromagnetkörpern umgeben, so daß nicht ersichtlich ist, wie der Patient in den Probenraum gelangt und wie die Spulen zum Erzeugen des Magnetfeldes im einzelnen verlaufen sollen. Das Magnetsystem dieser bekannten Anordnung ist damit für einen praktischen Gebrauch gänzlich ungeeignet, da es an einer Öffnung zum Einbringen des Meßobjektes fehlt und darüber hinaus Magnetdimensionen erforderlich sind, für die eine Realisierung als Eisenmagnet aus Gewichtsgründen ausscheidet.

Für die Beurteilung der vorliegenden Erfindung ist auch beachtlich, daß in den grundlegenden Arbeiten auf dem Gebiet der Kernspintomographie die Verwendung von Elektromagneten für Messungen am menschlichen Körper aus Dimensionsgründen als nicht praktikabel bezeichnet wurde (z. B. Electro/78 Conference Record, 23. - 25. Mai 1978, Seiten 30/21 - 15, Boston, USA). Auch bei den gegenwärtig kommerziell erhältichen Kernspintomographen werden ausschließlich Luftspulen-Anordnungen verwendet. Der vorliegenden Erfindung kommt daher das Verdienst zu, dieses Vorurteil überwunden und erstmals eine Möglichkeit aufgezeigt zu haben, einen Kernspintomographen für Messungen am menschlichen Körper mit einem Eisenmagneten zu realisieren.

In einer besonders bevorzugten Ausführungsform der Erfindung ist je ein Paar Spulenabschnitte in den Ecken der im Querschnitt rechteckigen Längsöffnung angeordnet. Diese Anordnung erleichtert das Wickeln der erforderlichen Spulen, insbesondere das Abkröpfen im Bereich der Außenöffnung. Zum anderen führt eine im Querschnitt rechteckige Längsöffnung zu einer bereits ohne weitere Hilfsmittel guten Grundhomogenität des Magnetfeldes. Schließlich sind bei einer derartigen Längsöffnung auch verschiebbare Patientenliegen leicht anzubringen.

Eine besonders gute Wirkung wird dabei dadurch erzielt, daß die genannten Spulenabschnitte in vorzugsweise zwei Richtungen senkrecht zur Achse der Längsöffnung verschieblich sind. Mit einer derartigen Verschiebung der Spulenabschnitte kann in besonders einfacher Weise die Homogenität des Feldes verbessert werden.

Eine weitere Erhöhung der Homogenität des Feldes ist erfindungsgemäß dadurch möglich, daß in der Längsöffnung zur Feldkorrektur Längsshims in Gestalt von ferromagnetischen Profilen angeordnet sind. Diese Profile können entweder im Randbereich der Öffnung angeordnet sein und damit einen Randabfall des Feldes kompensieren oder auch in der Mitte der Öffnung, so daß eine Feldeinsenkung im Mittenbereich kompensiert wird.

Eine entsprechende Homogenisierung des Magnetfeldes ist ferner dadurch möglich, daß im inneren Randbereich des Eisenkörpers eine die Längsöffnung begrenzende weichmagnetische Platte angeordnet ist, die über Verstellmittel in wenigstens einer Richtung senkrecht zur Achse der Längsöffnung verstellbar ist. Gestaltet man die Verstellung beispielsweise mit einer Spindel, kann die Homogenität des Magnetfeldes besonders feinfühlig eingestellt werden.

Obwohl durch das erfindungsgemäß verwendete Magnetsystem Streufelder bereits auf ein Minimum reduziert sind, kann eine Kompensation des Restfeldes bevorzugt dadurch erreicht werden, daß der Eisenkörper mit die Längsöffnung verschliessenden weichmagnetischen Deckplatten versehen ist, die im wesentlichen nur den Austrittsbereich der Spulenabschnitte sowie vorzugsweise eine Öffnung zum Einbringen des Meßobjektes freilassen und sich bis in den an die Längsöffnung grenzenden Randbereich des Eisenkörpers hinein erstrecken. Bei Vorsehen derartiger Deckplatten entsteht ein praktisch allseits geschlossener Eisenkörper, so daß Störungen von außen nach innen und von innen nach außen praktisch vollkommen unterdrückt werden.

Schließlich kann in erfindungsgemäßer Ausgestaltung das verwendete Magnetsystem entweder so ausgerichtet sein, daß das Meßobjekt, insbesondere ein Patient, in liegender Position in das Magnetsystem geschoben wird, es ist jedoch auch möglich, das Magnetsystem mit senkrecht im Raum angeordneter Achse auszubilden, so daß der Patient im Sitzen oder Stehen untersucht werden kann.

Weitere Vorteile ergeben sich aus der Beschreibung und der beigefügten Zeichnung.

Die Erfindung ist in der Zeichnung dargestellt und wird in der nachfolgenden Beschreibung näher erläutert.

Es zeigen:

Fig. 1 eine perspektivische Darstellung eines Teiles einer Ausführungsform eines erfindungsgemäßen Kernspintomographen;

Fig. 2 eine schematische Frontansicht eines erfindungsgemäß verwendeten Magnetsystems;

Fig. 3 eine Darstellung entsprechend Fig. 2 mit verschiedenen Mitteln zum Korrigieren des Magnetfeldes;

Fig. 4 eine Darstellung entsprechend Fig. 2, bei der Abschirm-Deckplatten vorgesehen sind.

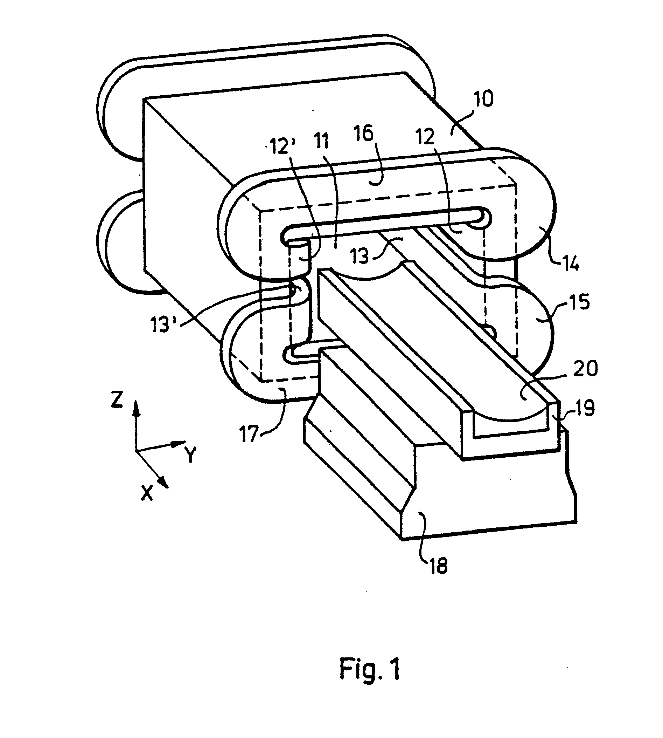

In der perspektivischen Darstellung von Fig. 1 ist 10 ein Eisenkörper von quaderförmiger Gestalt, den eine Längsöffnung 11 von rechteckigem Querschnitt in einer Achse durchsetzt. Die Achse der Längsöffnung 11 ist mit x und die dazu senkrechten Achsen sind mit z und y bezeichnet. Im Hinblick auf den umgebenden Raum verlaufen die Achsen x und y waagerecht und die Achse z verläuft senkrecht. Dies ist jedoch lediglich im Ausführungsbeispiel gemäß Fig. 1 so, es ist selbstverständlich auch möglich, die Anordnung von Fig. 1 im Raume anders anzuordnen, beispielsweise derart, daß die Achse x senkrecht im Raum steht, so daß ein Patient im Stehen oder Sitzen untersucht werden kann, wie dies im einzelnen in der erwähnten DE-A-3 123 493 geschildert ist.

In der Längsöffnung 11 verlaufen insgesamt vier Spulenabschnitte. In den oberen Ecken der rechteckförmigen Längsöffnung 11 verlaufen Flachspulen 12 und 12' und in den unteren Ecken Flachspulen 13 und 13'. Die Flachspulen 12 und 13 sind an den mit 14 und 15 bezeichneten Stellen im Austrittsbereich der Längsöffnung 11 aus dem Eisenkörper 10 zunächst um 90° in y-Richtung abgekröpft und dann um 180° in z-Riichtung nach oben umgebogen, verlaufen dort an den mit 16 und 17 bezeichneten Stirnseiten in y-Richtung und schließen sich an der gegenüberliegenden Seite der Längsöffnung 11 zu den Spulenabschnitten 12' und 13' in entsprechender Weise. Die Anordnung an der entgegengesetzten Stirnseite des Eisenkörpers 10 ist entsprechend.

Auch diese Anordnung ist lediglich beispielhaft zu verstehen. Es versteht sich, daß statt der im Ausführungsbeispiel gemäß Fig. 1 dargestellten zwei Spulenpaare 12, 12' und 13, 13' auch lediglich ein einziges Spulenpaar oder noch mehr Spulenpaare verwendet werden können. Auch kann z. B. der Spulenabschnitt 12 im Austrittsbereich zunächst nach oben um 90° abgekröpft sein und dann wiederum um 90° in y-Richtung umgekröpft werden.

Außerhalb des Eisenkörpers 10 befindet sich ein Stativ 18, auf dem eine Führung 19 für eine Liege 20 befestigt ist. Die Liege 20 dient zur Aufnahme eines Meßobjektes, beispielsweise eines Patienten, und ist in x-Richtung in die Längsöffnung 11 hinein verschiebbar.

Aus Gründen der Einfachheit und Übersichtlichkeit sind in Fig. 1 die weiteren Spulenanordnungen zum Erzeugen der Gradientenfelder und des Hochfrequenzfeldes ebenso wenig eingezeichnet wie die zum Verarbeiten der Daten und Darstellung der Schnittbilder erforderlichen elektronischen Geräte. Diese Einheiten sind jedoch an sich bekannt und brauchen daher im Rahmen der vorliegenden Anmeldung nicht näher erläutert zu werden.

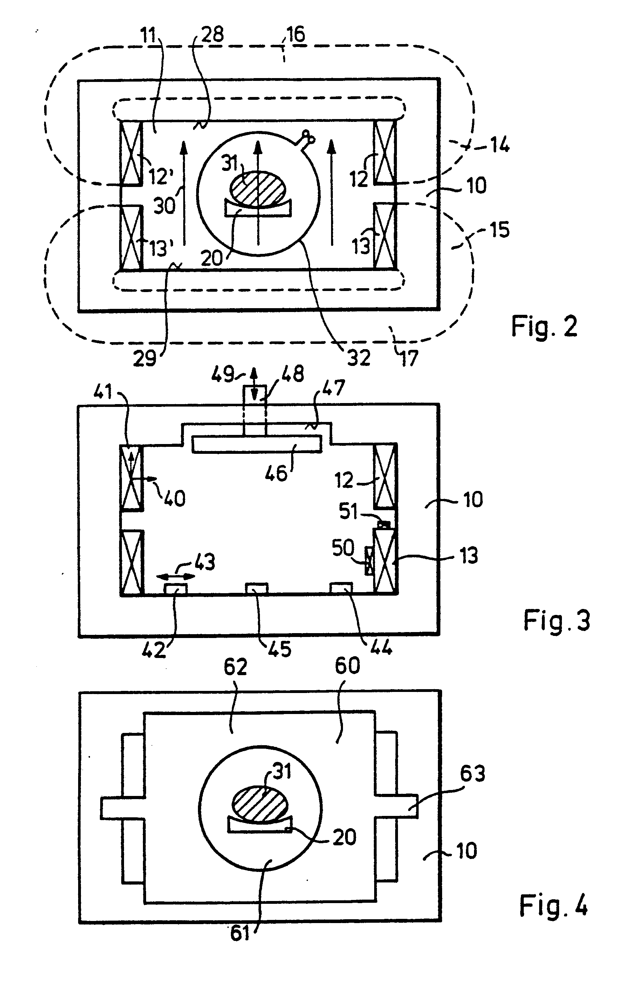

Fig. 2 ist eine vereinfachte Frontansicht der Darstellung von Fig. 1. Man erkennt wiederum den Eisenkörper 10 mit der Längsöffnung 11 sowie den Spulenpaaren 12, 12' und 13, 13', die sich in der oben beschriebenen Weise über die Abschnitte 14, 15, 16, 17 schließen.

Die genannten Spulen erzeugen ein Magnetfeld, das sich in sehr homogener Weise über den Raum der Längsöffnung 11 zwischen Deckflächen 28 und 29 erstreckt und sich außen über die Seitenwände des Eisenkörpers 10 schließt. Dieses von dem Spulensystem 12, 13 erzeugte Konstantmagnetfeld ist in Fig. 2 mit 30 angedeutet. Es durchsetzt das auf der Liege 20 angeordnete Meßobjekt 31 in der eingezeichneten Weise, d.h. einen auf der Liege 20 liegenden Patienten in einer Achse senkrecht zu dessen Längsachse. Zum Einstrahlen des benötigten Hochfrequenzfeldes ist eine Hochfrequenz-Spule 32 vorgesehen, die bei dem in Fig. 2 dargestellten Ausführungsbeispiel eine Ebene in z y-Richtung aufspannt. Es versteht sich jedoch, daß die Spule 32 auch gegenüber der Darstellung in Fig. 2 um 90° verdreht angeordnet sein kann, so daß sie eine Ebene in z x-Richtung aufspannt.

Bei der Darstellung gemäß Fig. 3, die der Ansicht gemäß Fig. 2 entspricht, sind die zur Korrektur des Magnetfeldes im einzelnen vorgesehenen Mittel eingetragen.

Zunächst können die Spulen 12, 12', 13, 13' in Richtungen 40, 41, d.h. in y- und z-Richtung verschiebbar angeordnet sein. Zum anderen können in x-Richtung in der Längsöffnung 11 sog. Längsshims 42, 44, 45 angeordnet sein, die im wesentlichen die Gestalt von ferromagnetischen Profilen, vorzugsweise Rechteckprofilen, haben. Diese Shims 42, 44, 45 können ihrerseits in einer Richtung 43, d.h. in y-Richtung, verschiebbar sein. Findet man beispielsweise daß das Feldprofil in y-Achse des Konstantmagnetfeldes 30 einen balligen Verlauf mit abfallenden Flanken

hat, wird man im Randbereich liegende Längsshims 42 und 44 vorsehen, die eine Felderhöhung im Randbereich bewirken, so daß der ohne Shims vorliegende Feldabfall kompensiert werden kann. Findet man hingegen, daß der Feldverlauf in y-Richtung in der Mitte eingesenkt ist, wird man einen zentralen Längsshim 45 vorsehen, der eine Felderhöhung in der Mitte bewirkt und damit die genannte Einsenkung in der Mitte kompensiert.

Weiterhin kann man zur Erhöhung der Feldhomogenität eine Weicheisenplatte 46 vorsehen, die sich in Achsrichtung der Längsöffnung 11 erstreckt. Die Weicheisenplatte 46 befindet sich in einer Ausnehmung 47 der Deckfläche 28 oder der Bodenfläche 29 und ist, beispielsweise über eine bei 48 vorgesehene Spindel in einer Richtung 49 in der z-Achse verschiebbar.

Schließlich können die Spulen 12, 13 auch mit Korrekturspulen 50, 51 versehen sein, die auf die Spulen 12, 13 in z-oder y-Richtung aufgesetzt sind.

Wie man bereits aus Fig. 2 erkennt, bewirkt der Eisenkörper 10 durch seine, die Längsöffnung 11 nahezu vollständig umschließende Struktur bereits eine weitgehende Abschirmung des Innenraumes, so daß weder Störungen von außen nach innen dringen können, noch Störfelder des Magnetsystems außerhalb des Magnetsystems befindliche Einrichtungen beeinflussen können.

Um jedoch auch noch die geringen, im Austrittsbereich der Längsöffnung 11 auftretenden Störfelder zu kompensieren, ist in weiterer Ausgestaltung der Erfindung gemäß Fig. 4 vorgesehen, die Längsöffnung 11 einseitig oder beidseitig mit einer Deckplatte 60 zu verschließen, die lediglich einen Raum für den Austritt der Spulen 12, 12' und 13, 13' freiläßt. Die Deckplatte 60 reicht in Randbereichen 62, 63 bis in die Stirnseite des Eisenkörpers 10 hinein, so daß die Feldlinien des noch verbleibenden Streufeldes sicher geschlossen werden. Man kann dabei die Deckplatte 60 an einer oder an beiden Seiten mit einer Öffnung 61 versehen, die so bemessen ist, daß das Meßobjekt 31 auf der Liege 20 hindurchgefahren werden kann.

Es versteht sich, daß die Darstellung gemäß Fig. 4 nur als Schemadarstellung zu verstehen ist, Schwenkeinrichtungen für die Deckplatte 60, Scharniere u. dgl. sind der Übersichtlichkeit halber fortgelassen.

**Patentansprüche**

1. Kernspintomograph mit einem Magnetsystem, in dessen einer Achse eine vorzugsweise längsverschiebliche und langgestreckte Halterung für ein Meßobjekt (31) angeordnet ist, wobei das Meßobjekt (31) ferner von Spulensystemen zum Erzeugen von Gradientenfeldern und zum Einstrahlen eines Hochfrequenzfeldes umgeben ist, dadurch gekennzeichnet, daß das Magnetsystem einen eine Längsöffnung (11) zur Aufnahme des Meßobjektes (31) umschließenden Jocheisenkörper (10) aufweist, wobei in äußeren Randbereichen der Längsöffnung (11) Spulenabschnitte (12, 12'; 13, 13') in Richtung der Längsöffnung (11) verlaufen, die im Austrittsbereich aus der Längsöffnung (11) abgekröpft sind und sich oberhalb der Längsöffnung (11) schließen.

2. Kernspintomograph nach Anspruch 1, dadurch gekennzeichnet, daß je ein Paar Spulenabschnitte (12, 12'; 13, 13') in den Ecken der im Querschnitt rechteckigen Längsöffnung (11) angeordnet ist.

3. Kernspintomograph nach Anspruch 1 oder 2, dadurch gekennzeichnet, daß die Spulenabschnitte (12, 12', 13, 13') in vorzugsweise zwei Richtungen (40, 41) senkrecht zur Achse der Längsöffnung (11) verschiebbar sind.

4. Kernspintomograph nach einem der Ansprüche 1 bis 3, dadurch gekennzeichnet, daß der Längsöffnung (11) zur Feldkorrektur Längsshims (42, 44, 45) in Gestalt von ferromagnetischen Profilen angeordnet sind.

5. Kernspintomograph nach einem der Ansprüche 1 bis 4, dadurch gekennzeichnet, daß im inneren Randbereich des Jocheisenkörpers (10) eine die Längsöffnung (11) begrenzende weichmagnetische Platte (46) angeordnet ist, die über Verstellmittel in wenigstens einer Richtung (49) senkrecht zur Achse der Längsöffnung (11) verstellbar ist.

6. Kernspintomograph nach einem der Ansprüche 1 bis 5, dadurch gekennzeichnet, daß der Jocheisenkörper (10) mit die Längsöffnung (11) verschließenden weichmagnetischen Deckplatten (60) versehen ist, die im wesentlichen nur den Austrittsbereich der Spulenabschnitte (12, 13) sowie vorzugsweise eine Öffnung (61) zum Einbringen des Meßobjektes (31) freilassen und sich bis in den an die Längsöffnung (11) grenzenden Randbereich des Jocheisenkörpers (10) hinein erstrecken.

7. Kernspintomograph nach einem der Ansprüche 1 bis 6, dadurch gekennzeichnet, daß die Achse x der Längsöffnung (11) horizontal im Raum liegt.

8. Kernspintomograph nach einem der Ansprüche 1 bis 6, dadurch gekennzeichnet, daß die Achse der Längsöffnung (11) senkrecht im Raum steht.

**Claims**

1. NMR tomograph with a magnet system, in one axis of which is arranged a preferably longitudinally displaceable, elongated mounting support for a target (31), the latter being surrounded by coil systems for producing gradient fields and for radiating in a high frequency field, characterized in that the magnet system has a yoke iron body (10) surrounding a longitudinal opening (11) for receiving the target (31), coil sections (12, 12', 13, 13') running in the direction of the longitudinal opening (11) in the outer marginal region of the latter and in the exit region from longitudinal opening (11) are offset and close above longitudinal opening (11).

2. NMR tomograph according to claim 1, characterized in that in each case one pair of coil sections (12, 12', 13, 13') is arranged in the corners of the cross-section rectangular longitudinal opening (11).

3. NMR tomograph according to claims 1 or 2, characterized in that the coil sections (12, 12', 13, 13') are displaceable in preferably two directions (40, 41) at right angles to the axis of longitudinal opening (11).

4. NMR tomograph according to one of the claims 1 to 3, characterized in that longitudinal shims (42, 44, 45) in the form of ferromagnetic profiles are arranged in the longitudinal opening (11) for field correction purposes.

5. NMR tomograph according to one of the claims 1 to 4, characterized in that in the inner marginal region of the yoke iron body (10) is arranged a soft magnetic plate (46) bounding the longitudinal opening (11) and which is adjustable by adjusting means in at least one direction (49) at right angles to the axis of longitudinal opening (11).

6. NMR tomograph according to one of the claims 1 to 5, characterized in that the yoke iron body (10) is provided with soft magnetic cover plates (60) closing the longitudinal opening (11) and which essentially only leaves open the exit region of the coil section (12, 13) and preferably an opening (61) for the introduction of the target (31) and extend into the marginal region of the yoke iron body (10) adjacent to longitudinal opening (11).

7. NMR tomograph according to one of the claims 1 to 6, characterized in that axis x of longitudinal opening (11) is horizontal in space.

8. NMR tomograph according to one of the claims 1 to 6, characterized in that the axis of the longitudinal opening (11) is at right angles in space.

**Revendications**

1. Tomographe à résonance magnétique nucléaire comportant un système magnétique dans un axe duquel est disposé un support pour un objet (31) à mesurer, ledit support étant de préférence prévu pour être déplacé dans le sens longitudinal et s'étendant dans sa longueur, où l'objet (31) à mesurer étant de plus entouré de systèmes de bobines agencées pour engendrer des champs magnétiques à gradient et pour y irradier un champ à haute fréquence, caractérisé en ce que le système magnétique comporte un corps (10) en fer en forme de joug qui enveloppe une ouverture (11) longitudinale pour la réception de l'objet (31) à mesurer, où aux alentours des bords extérieurs de l'ouverture (11) longitudinale s'étendent dans la direction de l'ouverture (11) longitudinale, des sections (12, 12'; 13, 13') de bobines, lesdites sections étant coudées aux alentours de la sortie de l'ouverture (11) longitudinale et se refermant au-dessus de l'ouverture (11) longitudinale.

2. Tomographe à résonance magnétique nucléaire suivant la revendication 1, caractérisé en ce que dans les coins de l'ouverture (11) longitudinale, qui possède une section rectangulaire, est chaque fois disposée une paire de sections de bobines (12, 12'; 13, 13').

3. Tomographe à résonance magnétique nucléaire suivant l'une des revendications 1 ou 2, caractérisé en ce que, les sections de bobines (12, 12'; 13, 13') peuvent de préférence être déplacées dans deux directions (40, 41) qui sont perpendiculaires à l'axe de l'ouverture longitudinale (11).

4. Tomographe à résonance magnétique nucléaire suivant l'une des revendications 1 à 3, caractérisé en ce que, des cales longitudinales (42, 44, 45), ayant la forme de profils ferromagnétiques, sont disposées dans l'ouverture (11) longitudinale pour permettre la correction du champ.

5. Tomographe à résonance magnétique nucléaire suivant l'une des revendications 1 à 4, caractérisé en ce que, aux alentours intérieurs du bord du corps (10) en fer en forme de joug est disposée une plaque (46) magnétique souple qui délimite l'ouverture (11) longitudinale, ladite plaque magnétique étant ajustable à l'aide de moyens d'ajustement dans au moins une direction (49) perpendiculaire à l'axe de l'ouverture (11) longitudinale.

6. Tomographe à résonance magnétique nucléaire suivant l'une des revendications 1 à 5, caractérisé en ce que, le corps (10) en fer en forme de joug est pourvu de plaques (60) magnétiques souples de recouvrement enveloppant l'ouverture (11) longitudinale, lesdites plaques de recouvrement ne laissant libre qu'essentiellement les alentours de la sortie des sections de bobines (12, 13) ainsi que de préférence une ouverture (61) pour y entrer l'objet (31) à mesurer et s'entendent jusqu'à l'intérieur des alentours du bord du corps (10) en fer en forme de joug qui est voisin de l'ouverture (11) longitudinale.

7. Tomographe à resonance magnétique nucléaire suivant l'une des revendications 1 à 6, caractérisé en ce que l'axe x de l'ouverture (11) longitudinale s'étend horizontalement dans le volume du corps.

8. Tomographe à résonance magnétique nucléaire suivant l'une des revendications 1 à 6, caractérisé en ce que l'axe de l'ouverture (11) longitudinale s'étend perpendiculairement dans le volume du corps.

Fig. 1

Fig. 2

Fig. 3

Fig. 4